## Europäisches Patentamt

## European Patent Office

## Office européen des brevets

(11) Publication number: **0 134 731**
**B1**

(12) **EUROPEAN PATENT SPECIFICATION**

(45) Date of publication of patent specification: **12.10.88**

(21) Application number: **84401438.1**

(22) Date of filing: **06.07.84**

(51) Int. Cl.⁴: **H 03 K 19/08, H 03 K 19/094,
H 03 K 19/01, H 03 K 19/003**

(54) Complementary logic integrated circuit.

(30) Priority: **08.07.83 JP 123499/83
08.07.83 JP 123500/83**

(43) Date of publication of application:
**20.03.85 Bulletin 85/12**

(45) Publication of the grant of the patent:
**12.10.88 Bulletin 88/41**

(84) Designated Contracting States:
**DE FR GB**

(56) References cited:
**EP-A-0 099 100
GB-A-2 080 651
US-A-3 649 851
US-A-3 879 619
US-A-4 021 684
US-A-4 103 188**

(73) Proprietor: **FUJITSU LIMITED
1015, Kamikodanaka Nakahara-ku
Kawasaki-shi Kanagawa 211 (JP)**

(72) Inventor: **Ohba, Osam
536-5-2-303, Ohmaru
Inagi-shi Tokyo 206 (JP)**
Inventor: **Tanizawa, Tetsu
7-1-301, Hosoyama 1 Chome Asao-ku
Kawasaki-shi Kanagawa, 215 (JP)**

(74) Representative: **Descourtieux, Philippe et al
CABINET BEAU de LOMENIE 55 rue
d'Amsterdam
F-75008 Paris (FR)**

Courier Press, Leamington Spa, England.

# Description

The present invention relates to a complementary logic integrated circuit, more precisely, to a complementary IC (Integrated Circuit) which enables high speed switching of signals at high current level without increasing power consumption. The circuit according to the present invention is provided with pull-up or pull-down elements which pull up or pull down the level of the output signal to a value close to that of the power supply voltage. The circuit is realized by combining MIS (Metal Insulator Semiconductor) transistors with bipolar transistors or vertical FETs (Field Effect Transistors).

Complementary MIS (C-MIS) type logic circuits are widely use as very low power consumption circuits, but have disadvantages of rather low switching speed and rather low power handling capacity. Therefore, it is difficult to drive a large scale and complicated logic circuit by means of C-MIS.

Attempts have been made to overcome such defects of complementary MIS circuit by combining MIS-FETs with bipolar transistors, especially vertical type bipolar transistors, which have high speed and high power handling capacity. Such circuits are called sometimes Bi-MIS circuits and are used widely (for example, U.S. Pat. Application No. 373843 which is published as US—A—3879619 and, is laid open in Japan with Provisional Publication No. 38454/'75, by C. H. Grady). But other difficulties appeared with such improved circuits, as will be described later, and the improvement appeared to be inadequate. The main problem is the lack of signal amplitude to operate a large and complicated C-MIS circuit. The insufficient signal level causes a slightly-ON state in the C-MIS logic circuit which is driven by the Bi-MIS circuit. Another problem consists in a rush current which runs through the bipolar transistors at the transient of the switching. This increases the dark current and temperature of the IC chip, and the increased temperature imposes undesirable effects on the reliability of the devices.

The object of the present invention is, therefore, to provide an improved complementary logic circuit which has high switching speed and high power handling capacity, and still operates with low power consumption.

Another object of the present invention is to provide a complementary logic circuit which delivers a large amplitude signal, which is sufficient to drive a C-MIS circuit.

Foregoing objects are attained by combining C-MIS with bipolar transistors or vertical FETs, and further providing them with elements which pull down or pull up the level of output signals to a level close to the source voltage.

In a first aspect, the invention relates to a complementary logic IC (Integrated Circuit) containing an input stage circuit which comprises a first conductivity type channel MIS-FET and an opposite conductivity type channel MIS-FET, whose gates are connected to each other and receive an input signal, characterized by:

an output stage circuit which comprises a p-channel V-FET (vertical FET) and an n-channel V-FET, whose drains are connected to each other and provide an output signal, and whose sources are connected respectively to a positive and a negative voltage supply source, with each of said MIS-FETs being connected respectively between the gate and drain of said p-channel and n-channel V-FETs; and

pull-up and pull-down elements respectively provided between the gate and the voltage supply source of said p-channel and n-channel V-FETs.

In another aspect, the invention is applicable to a circuit with an output stage using complementary bipolar transistors.

US—A—3 649 851 relates to such a circuit, in which pull-up and pull-down elements are provided. However, these elements are resistors and the input stage comprises also bipolar transistors, not MIS-FETs.

According to this aspect of the invention, in a complementary logic IC (Integrated Circuit) comprising:

an output stage circuit which comprises a pnp type bipolar transistor and a npn type bipolar transistor, whose collectors are connected to each other and provide an output signal, and whose emitters are connected respectively to a positive and a negative voltage supply source, and

an input stage circuit which comprises a first conductivity type channel MIS-FET (Metal Insulator Semiconductor type Field Effect Transistor) and an opposite conductivity type channel MIS-FET, each connected respectively between the base and collector of said pnp and npn type bipolar transistors, and whose gates are connected to each other and receive an input signal,

It is provided that pull-up and pull-down elements constituted by FETs respectively connect the base and the voltage supply source of said pnp and npn bipolar transistors by means of the channel portion of said FETs, the gate of said FETs being so connected that the pull-up and pull-down function is respectively obtained.

For an inverting type logic, the circuit according to the present invention comprises a first (input) stage circuit which is composed of a pair of p-channel and n-channel MIS transistors, and a second (output) stage circuit which is composed of a pair of pnp type and npn type bipolar transistor. For a non-inverting type logic, the logic circuit according to the present invention comprises a first (input) stage circuit which is composed of a pair of n-channel and p-channel MIS transistors, and a second (output) stage circuit which is composed of a pair of pnp type and npn type bipolar transistors. Each pair of MIS transistors and bipolar transistors forms a respective complementary circuit.

Each bipolar transistor is provided with a pull-up or pull-down element which is connected between the base electrode and the voltage source. These elements substantially pull down or pull up the output voltage of the circuit to a value close to the source voltage, and the above mentioned defects of the complementary MIS logic circuit are eliminated.

The effects and features of the invention will become clear from the following detailed description made with reference to the accompanying drawings.

Fig. 1a shows a prior art Bi-MIS logic circuit, which is an inverting type circuit; and

Fig. 1b shows a Bi-MIS logic cirucit which is a non-inverting type circuit.

Fig. 2 shows a circuit diagram of improved complementary logic circuits according to the present invention which are provided with pull-up and pull-down elements, wherein:

Fig. 2a shows an inverting type circuit; and

Fig. 2b shows a non-inverting type circuit.

Fig. 3 shows a circuit diagram of improved complementary logic circuits corresponding to those of Fig. 2, in which the bipolar transistors are replaced by vertical FETs, wherein:

Fig. 3a shows an inverting type circuit; and

Fig. 3b shows a non-inverting type circuit.

Fig. 4 shows circuit diagrams of circuitries which can be used for the pull-up or pull-down element in the circuit of the present invention, wherein:

Fig. 4.1 shows a circuitry using a resistor;

Fig. 4.2 shows a circuitry using a depletion type MIS-FET;

Fig. 4.3 shows a circuitry using a MIS-FET; and

Fig. 5 shows another embodiment of the present invention illustrating another connection of the circuit which enhances the pull-up and pull-down action, wherein:

Fig. 5a shows an inverting type circuit; and

Fig. 5b shows an non-inverting type circuit.

In each drawing, figures having a suffix "a" indicate inverting type logic circuits, and figures having a suffix "b" indicate non-inverting type logic circuits. Similar notations or reference numerals designate similar or corresponding part throughout the drawings.

As mentioned before, though the complementary FET (C-FET) logic circuits have merits of low power consumption and easy fabrication, they also show defects.

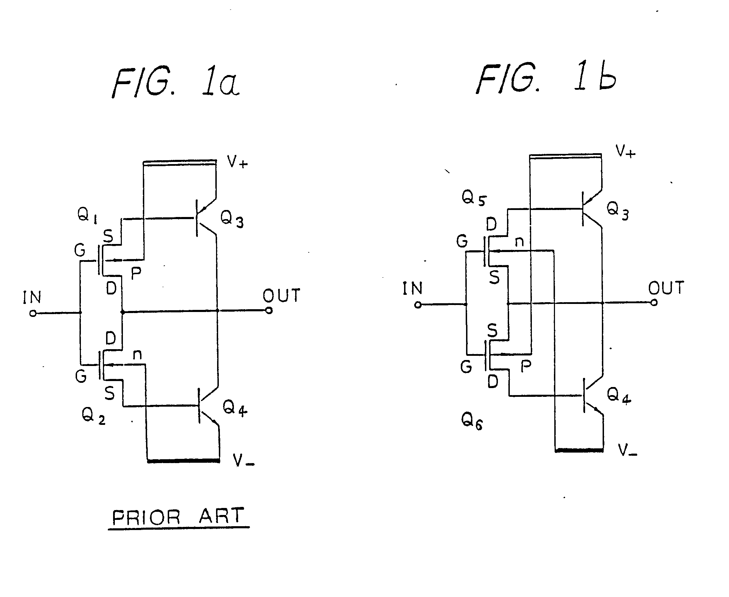

Fig. 1 shows examples of Bi-MIS (combined Bipolar and MIS) complementary logic circuits, where Fig. 1a shows an inverting type, and Fig. 1b shows a non-inverting logic circuit. The first stage is an inverter circuit composed of complementary MIS transistors $Q_1$ (p-channel) and $Q_2$ (n-channel). The second stage (output stage) is a buffer amplifier composed of complementary bipolar transistors $Q_3$ (pnp) and $Q_4$ (npn). The gate electrodes of the MIS transistors $Q_1$ and $Q_2$ are connected to each other and receive the input signal IN. The source electrodes of MIS transistors $Q_1$ and $Q_2$ are respectively connected to the base electrodes of the bipolar transistors $Q_3$ and $Q_4$. The drain electrodes of the MIS transistors $Q_1$ and $Q_2$, and the collector electrodes of the bipolar transistors $Q_3$ and $Q_4$ are connected to each other and provide the output signal OUT. The emitter electrodes of the bipolar transistors $Q_3$ and $Q_4$ are respectively connected to positive and negative voltage sources $V_+$ AND $V_-$.

The operation of the circuit is as follows. When the input signal IN becomes H (high level), the n-channel MIS transistor $Q_2$ is ON (conductive) and the base electrode of the bipolar transistor $Q_4$ is pulled up to a high level, because current is supplied from the output side. Namely, before the beginning of the switching action, IN was at low level and OUT was at high level; thus, the stray capacity of the output circuit supplies the current to charge up the base of the transistor $Q_4$ through the transistor $Q_2$, and, therefore, the transistor $Q_4$ also becomes ON, and the output signal becomes L (low level).

On the contrary, when the input signal IN becomes L, the p-channel MIS transistor $Q_1$ is ON, and the base electrode of the pnp transistor $Q_3$ is pulled down, so that the transistor $Q_3$ becomes ON and the output signal OUT becomes H (high level). Ultimately, the MIS transistor $Q_2$ and the npn transistor $Q_4$ are both in cut off state. Therefore, the all over circuit is of the inverting type.

As described above, when the input signal IN is H, the transistors $Q_1$ and $Q_3$ are cut off, and when the input signal is L, the transistors $Q_2$ and $Q_4$ are cut off. Therefore, when the switching action is over and in stable state, the drak current which runs from the positive voltage source $V_+$ to the negative voltage source $V_-$ through the circuit is almost zero, so the power consumption of the circuit is very small.

The non-inverting type circuit can be realized by serially connecting inverting type circuits. But it can be realized as shown in Fig. 1b. The first stage of Fig. 1b is composed of non-inverting complementary MIS transistors $Q_5$ (n-channel) and $Q_6$ (p-channel). The second stage is similar to that of Fig. 1a.

The gate electrodes of the MIS transistors $Q_5$ and $Q_6$ are connected to each other and receive the input signal IN. The drain electrodes of the MIS transistors $Q_5$ and $Q_6$ are respectively connected to the base electrodes of the bipolar transistors $Q_3$ and $Q_4$. The source electrodes of the MIS transistors $Q_5$ and $Q_6$, and the collector electrodes of the transistors $Q_3$ and $Q_4$ are connected to each other and provide the output signal OUT. The emitter electrodes of the bipolar transistors $Q_3$ and $Q_4$ are respectively connected to the positive and negative voltage sources $V_+$ and $V_-$.

In the figure, the channel regions of the p-channel FETs $Q_1$ and $Q_6$ are supplied with positive voltage, and the channel region of the n-channel FETs $Q_2$ and $Q_5$ are supplied with negative voltage. This is a common way to use MIS-FETs.

The operation of the non-inverting circuit can be easily understood by analogy with the foregoing description for the one skilled in the art; therefore, it is omitted from this disclosure for sake of simplicity. In the cases of Fig. 1, the output circuit is composed of bipolar transistors, whose ON-resistance is much smaller than that of MIS-FETs, so it is possible to switch a high current signal, and drive a large complicated logic circuit which has inevitably a large stray capacitance, because the time constant of the circuit to switch from L to H or vice versa is determined by the stray capacity and the ON-resistance of the driver transistor.

But such an improvement is still inadequate. Generally in a C-MIS circuit it is necessary to drive the C-MIS circuit with sufficiently high level or low level signal. If not, one of the p or n-channel FETs in the C-MIS circuit turns to a slightly-ON state. The current from the positive voltage source to the negative voltage source through the C-MIS circuit is then not perfectly pinched off and the dark current increases. When the integration becomes high, and many of C-MIS gates are driven by such circuits, the probability to cause such a dark current increases, and the temperature rise of the IC chip imposes undesirable effect on the reliability.

Moreover, for a high speed C-MOS gate, each of the MOS transistors is designed with a threshold voltage $V_{th}(\simeq |V_{GS}|)$ of a very low value, for example 0.5~0.8 volt, in order to show a low ON-resistance and to attain high switching speed. It is, therefore, desirable to drive such a C-MOS circuit with H or L signal which is higher than the positive side source voltage minus 0.5 volt or lower than negative side source voltage plus 0.5 volt respectively.

In the circuit of Fig. 1, the output signal level is approximately $V_+ - V_{BE}$ for high level and $V_- + V_{BE}$, for low level, where $V_{BE}$ is the base-emitter forward voltage of the bipolar transistor $Q_3$ or $Q_4$. For an ordinary bipolar transistor, $V_{BE}$ is approximately 0.8 volt. This is in contradiction to the above mentioned requirements for the input signal for a C-MOS circuit. So when the circuit of Fig. 1 is used for driving a large scale complicated logic circuit, it often suffers from lack of driving voltage, and causes an increase of dark current and power consumption.

There exists another problem, that is the increase of the rush current of the Bi-MIS circuit. Foregoing explanation of Bi-MIS logic relates to the stable state. But the problem occurs at the transition between L to H or vice versa. At the beginning of the transition, considering that IN varies from L to H, the p-channel MIS transistor $Q_1$ and the pnp bipolar transistor $Q_3$ are still ON, and in this instant, the rush current from $V_+$ to $V_-$ through the transistors $Q_3$ and $Q_4$ becomes very large. This is serious for Bi-MIS circuits, because such rush current is amplified by bipolar transistors.

The present invention provides two means to improve the above mentioned problems. The first means consists in providing pull-up and pull-down elements to substantially reduce the $V_{BE}$, and increase the amplitude of the output signal to a value almost equal to the source voltage. Moreover, since the bipolar transistor is perfectly cut off, the rush current is reduced to a greater extent. The second means consists in replacing the bipolar transistors by vertical FETs (V-FETs), which have a very low ON-resistance corresponding to $V_{th}$. These two means can be applied at the same time. The construction and the effect of the present invention will be disclosed hereinafter.

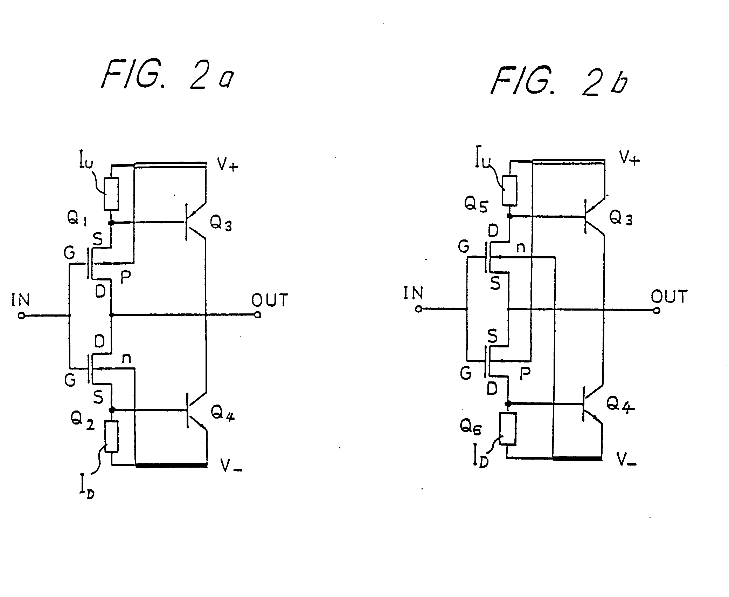

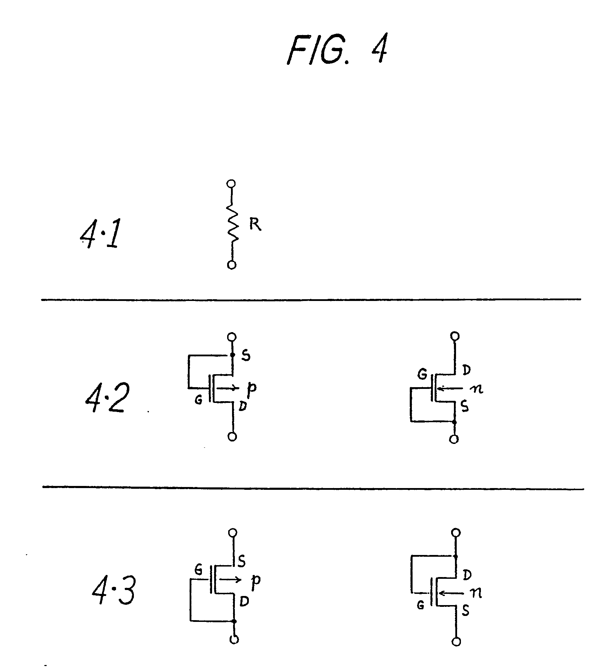

Fig. 2 shows a circuit diagram of an improved complementary logic circuit according to the present invention, wherein Fig. 2a shows an inverting type circuit and Fig. 2b shows a non-inverting type circuit. Comparing the figures with those of Fig. 1, it will be noticed that the improved circuits have an additional pull-up element $I_U$ which is connected between the base of pnp bipolar transistor $Q_3$ and the positive side of voltage source $V_+$, and an additional pull-down element $I_D$ which is connected between the base of the npn bipolar transistor $Q_4$ and the negative side of voltage source $V_-$. The pull-up and pull-down elements may be a resistor or some other circuitry, which will be described later with respect to Fig. 4.

The operation and effect of the pull-up and pull-down elements will be described with respect to the inverting type circuit of Fig. 2a, assuming that the pull-up and pull-down elements $I_U$ and $I_D$ are a resistor R. When the input signal IN begins to switch from L to H, the output signal OUT begins to drop in the same manner as described with respect to Fig. 1a. If a resistor R is not inserted, the output voltage will drop to $V_- + V_{BE}$ and the voltage drop will stop because, if the voltage goes down further, current would not flow through transistor $Q_4$, though the transistor $Q_4$ is in active state. But if the source S of the n-channel MIS transistor $Q_2$ is connected to $V_-$ through a resistor R as shown in Fig. 2a (in the figure it is indicated by $I_D$), the output voltage can go down further. In this case, the transistor $Q_4$ can be neglected, because there is no current in $Q_4$, so that the output voltage is determined by the serial connection of $Q_2$ and R. In this serial connection of $Q_2$ and R, the current is almost zero, (because the transistors $Q_1$ and $Q_3$ are in cut off state); therefore, the output voltage goes down to the value almost equal to $V_-$.

In the case, when the input signal turns from H to L, the transistors $Q_1$ and $Q_3$ are ON and the transistors $Q_2$ and $Q_4$ are OFF. Then, if the pull-up element $I_U$ is not connected, the output voltage will stop to rise at the value voltage $V_+ - V_{BE}$, because, if the voltage goes up further, current cannot flow through the transistor $Q_3$ though it is in active state. But, if the resistor R is connected between the source of transistor $Q_1$ and $V_+$, the output voltage is determined by the current running through the serial connection of R and $Q_1$. Since this current is almost zero, the output voltage goes up to a value almost equal to that of $V_+$.

The resistor R (the pull-up or pull-down element $I_U$ or $I_D$) has still other important effect. The explanation will be given with respect to the pull-down circuit. If the resistor R is not connected, that means the resistance is infinite, when a noise or surge voltage is induced in the output circuit, a current begins to run through the output transistor $Q_4$ since it is an active state. Of course, there is no problem for the transistor $Q_4$ to conduct the current, but trouble occurs when, at the same time, the input signal state varies from H to L and the transistor $Q_3$ begins to turn to the ON state. Then both transistors $Q_3$ and $Q_4$ become active at the same time, the current from the positive side to the negative side of the voltage source through the transistors $Q_3$ and $Q_4$ becomes very large, and the rush current increases. It will be understood that a similar trouble occurs when the input signal varies from L to H, if the pull-up element is not provided.

The probability for such a trouble to occur increases as the scale of integration becomes large. Therefore, the stabilization effect of the pull-up and pull-down elements are very important for large scale integrated circuits.

The second means to improve the Bi-MIS (combined circuit of Bipolar and MIS transistors) complementary logic circuit consists in replacing the bipolar transistor by vertical FETs (V-FETs).

The vertical FET is a field effect transistor whose channel is provided vertically to the surface of the transistor (ordinary FET has a channel parallel to the surface of the device). Vertical FET is known from the early stage of FET technology (for example, by J. Nishizawa et al. "Field Effect Transistor vs. Analog Transistor" IEEE Transaction on Electron Devices ED-22, No. 4, Apr. 1975 or by J. Nishizawa "Static Induction Transistor Logic" Jap. Journal of Applied Physics, Vol. 17, 1978 Supplement 17-1). But it was not used so widely, because of complexity of fabrication compared with ordinary bipolar transistors. But the inventors noticed that, when vertical FETs are used for the buffer stage of a complementary MIS (C-MIS) circuit, they show many advantages which overcome the defects of the C-MIS circuits.

The power handling capacity of vertical FET is large (because the carrier runs through the vertical channel), and the source-drain voltage at ON state, which corresponds to the $V_{BE}$ of a bipolar transistor, is very low. Therefore, the defects of the Bi-MIS circuit are eliminated and, moreover, the pull-up and pull-down elements can be applied similarly as for bipolar transistors.

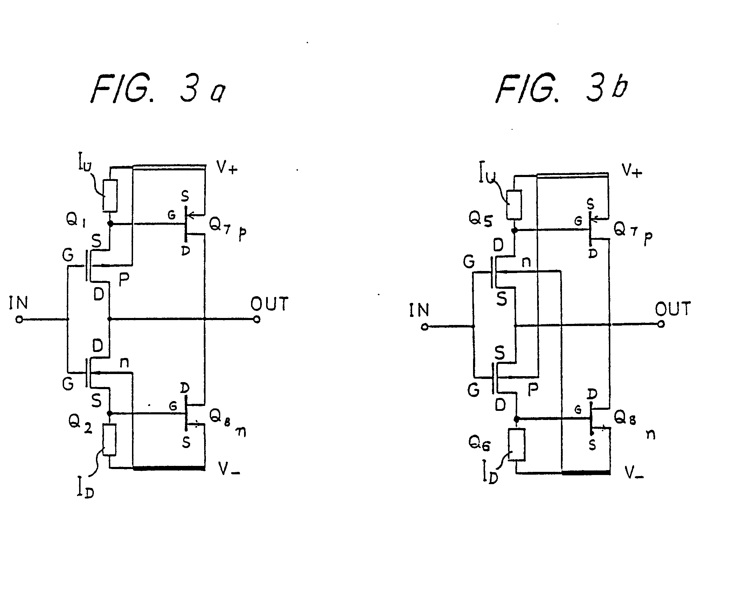

Fig. 3 shows circuit diagrams of a complementary logic circuit according to the present invention. Fig. 3a is a circuit diagram for an inverting type circuit, and Fig. 3b is a non-inverting type circuit. Fig. 3a and 3b correspond to Fig. 2a and 2b, respectively. As can be seen in the figures, the output stage transistors $Q_3$ and $Q_4$ are replaced respectively by a p-channel vertical FET $Q_7$ and a n-channel vertical FET $Q_8$. The operation is quite the same as that of the circuits of Fig. 2. Namely, the first stage is an inverting (Fig. 3a) or non-inverting (Fig. 3b) type C-MIS circuit and the second stage (output stage) is a non-inverting complementary vertical FETs circuit.

The vertical FETs $Q_7$ and $Q_8$ are connected in series between the positive and negative voltage sources $V_+$ and $V_-$. In any state of the signal (L or H), one of the vertical FETs is in OFF state. So, the current flowing directly from the positive source to the negative source is always pinched off and, therefore, the rush current or power consumption of the circuit is very small. The pull-up and pull-down elements can be applied, and the operation and effects are similar to those described with reference to Fig. 2.

In the foregoing explanation, the pull-up and pull-down elements were assumed to be a resistor R, but it may be in the form of some other circuitry. Fig. 4 shows some circuitries which can all be used as pull-up or pull-down elements.

Fig. 4.1 shows a circuitry constituted by a resistor R as described before. The pull-up resistor R is connected between the positive side terminal $V_+$ of the voltage source and the base electrode of the pnp transistor $Q_3$ (or gate electrode of p-channel V-FET $Q_7$). The pull-down resistor R is connected between the negative side terminal $V_-$ and the base electrode of the npn transistor $Q_4$ (or gate electrode of n-channel V-FET $Q_8$) as shown in Fig. 2 or Fig. 3. The value of the resistance is not critical, so long as it is equivalent to one or several times the ON-resistance of the C-MIS transistors $Q_1$, $Q_2$, $Q_5$ or $Q_6$, the range being preferably from one to ten times said ON-resistance.

A resistor is a simple but effective element for forming the pull-up and pull-down element. It can be easily fabricated in IC chips by conventional semiconductor technology such as diffusion or ion implantation, for example. It can be also fabricated on the surface of IC chip by spattering or other method. In any case, it is necessary to add a pattern for R. For this reason, in some cases it may be more convenient, from the view point of production, to make the pull-up and pull-down elements by the next described circuitries which do not require special pattern or additional process.

Fig. 4.2 shows pull-up and pull-down elements each in the form of a depletion type MIS-FET whose gate is connected to a respective source. By such a connection, the MIS-FETs work in constant current mode. This constant current source is better than the constant resistance R because, as long as the current flows, its internal resistance remains almost to zero, so that the pull-up or pull-down effect is better than with a resistor.

Such transistors (depletion type MIS-FETs) are included in plenty of conventional MIS logic circuits, so that it is not necessary to give a description of a process for their fabrication. They can be built altogether with the other transistors, which is convenient from the view point of manufacturing. The circuitry shown in Fig. 4.3 has the same merit.

Fig. 4.3 shows pull-up and pull-down elements each in the form of a depletion type MIS-FET whose gate is connected to a respective drain electrode. The functions and effects can be easily understood by analogy with the above explanation and their description is omitted for sake of simplicity.

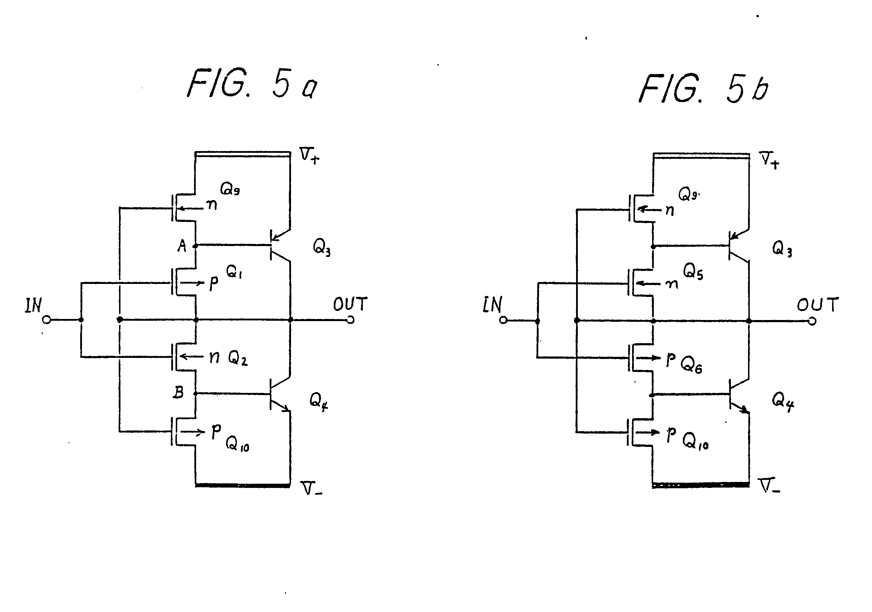

Fig. 5 shows another embodiment of the present invention, corresponding to Fig. 2, Fig. 5a shows an inverting type and Fig. 5b shows a non-inverting type circuit. Comparing Fig. 5a and Fig. 5b with Fig. 2a and Fig. 2b (together with Fig. 4.2), the difference is that the gate electrodes of the pull-up and pull-down elements are connected to the output terminal. By doing so, the pull-up and pull-down action is further enhanced. The pull-up transistor $Q_9$ is a n-channel MIS-FET, and the pull-down transistor $Q_{10}$ is a p-channel MIS-FET. The threshold voltage $V_{th}$ of these transistors $Q_9$ or $Q_{10}$ is almost zero or minus.

The operation is as follows. When the input signal IN starts to switch from L to H, the n-channel MIS transistor $Q_2$ turns to the ON state and the bipolar transistor $Q_4$ turns on the ON state. At this moment, the MIS-FET $Q_9$ is still ON, and the p-channel MIS-FET $Q_{10}$ is still receiving the initial H level of the output signal OUT, and is not conductive. So, the rush current of this circuit is very small; namely, it does not consume the base current of the npn bipolar transistor $Q_4$. Therefore, the switching speed to turn the npn transistor $Q_4$ ON is much faster than with other pull-down circuitry, and the total switching speed of the circuit is further enhanced.

When the level of the output signal OUT decreases to the level of $V_-$ plus $V_{BE}$, the operation mode of the circuit becomes to change. The p-channel MIS-FET $Q_{10}$ turns ON, and the current through the npn transistor $Q_4$, which is running from OUT to $V_-$, is switched from $Q_4$ to the serial path of $Q_2$ and $Q_{10}$. Then, the signal level begins to be in a stable state and remains in this state until the input signal varies.

When the input signal IN turns from H to L, the operation is similar to the above described operation. As the level of the output signal OUT increases, the pull-up transistor $Q_9$ turns to the ON state and pulls up the output signal to $V_+$. The pull-up action is similarly enhanced. When the output signal level increases up to $V_+ - V_{BE}$, the operation mode shifts from $Q_3$ to the serial path of $Q_9$ and $Q_1$. In any state of operation, either the transistors $Q_1$, $Q_3$ and $Q_9$ or the transistors $Q_2$, $Q_4$ and $Q_{10}$ are in OFF state. Therefore, the current running through the circuit from $V_+$ to $V_-$ is very small.

Fig. 5b shows a non-inverting type circuit. Comparing to Fig. 5a, the difference is that the p-channel MIS-FET $Q_1$ is replaced by a n-channel MIS-FET $Q_5$, and the n-channel MIS-FET $Q_2$ is replaced by a p-channel MIS-FET $Q_6$. The operation and effect are similar to those of the circuit on Fig. 2b. It will be easy for the one skilled in the art to understand said operation and effect and the description thereof is omitted for the sake of simplicity.

The complementary pair of output bipolar transistors $Q_3$, $Q_4$ of Figs. 5a, 5b could be replaced by a complementary pair of vertical FETs, $Q_7$, $Q_8$ (cf.

Figs. 3a, 3b). In such a case, the gates of the pull-up and pull-down MIS-FET $Q_9$, $Q_{10}$ should be connected to the drains of the output FETs $Q_7$, $Q_8$.

In the above embodiment of the pull-up and pull-down elements, the MIS-FETs may be replaced by V-FETs of corresponding type. The function and effect would be quite the same. Many other variations may be apparent for the one skilled in the art, for example, combining several kinds of circuitries shown in Fig. 4 to form the pull-up and pull-down elements, but they are all in the scope and spirit of the present invention. But it will be clear for the one skilled in the art that the embodiments of Figs. 4 and 5 are most effective, and, moreover, are easier and more practical to manufacture.

As has been described above, the complementary circuits according to the present invention eliminate the defects of the prior art C-MIS logic circuits, and provide high power handling capacity, high speed and stable operation with very low power consumption.

**Claims**

1. A complementary logic IC (Integrated Circuit) containing an input stage circuit which comprises a first conductivity type channel MIS-FET ($Q_1$; $Q_6$) and an opposite conductivity type channel MIS-FET ($Q_2$; $Q_5$), whose gates are connected to each other and receive an input signal (IN), characterized by:

an output stage circuit which comprises a p-channel V-FET (vertical FET) ($Q_7$) and an n-channel V-FET ($Q_8$), whose drains are connected to each other and provide an output signal (OUT), and whose sources are connected respectively to a positive and a negative voltage supply source, with each of said MIS-FETs being connected respectively between the gate and drain of said p-channel and n-channel V-FETs; and

pull-up and pull-down elements ($I_U$, $I_D$) respectively provided between the gate and the voltage supply source of said p-channel and n-channel V-FETs ($Q_7$, $Q_8$).

2. A complementary logic IC according to Claim 1, characterized in that said pull-up and pull-down elements are constituted by a resistor (R).

3. A complementary logic IC according to claim 2, characterized in that said resistor has a resistance value comprised between one and ten times the ON-resistance of said MIS-FETs.

4. A complementary logic IC (Integrated Circuit) comprising:

an output stage circuit which comprises a pnp type bipolar transistor ($Q_3$) and an npn type bipolar transistor ($Q_4$), whose collectors are connected to each other and provide an output signal (OUT), and whose emitters are connected respectively to a positive and a negative voltage supply source ($V_+$, $V^-$), and

an input stage circuit which comprises a first conductivity type channel MIS-FET (Metal Insulator Semiconductor type Field Effect Transistor) ($Q_1$; $Q_6$) and an opposite conductivity type

channel MIS-FET (Q_2; Q_5), each connected respectively between the base and collector of said pnp and npn type bipolar transistors, and whose gates are connected to each other and receive an input signal (IN), characterized by the fact that pull-up and pull-down elements constituted by FETs (Q_9, Q_10) respectively connect the base and the voltage supply source of said pnp and npn bipolar transistors (Q_3, Q_4) by means of the channel portion of said FETs, the gate of said FETs being so connected that the pull-up and pull-down function is respectively obtained.

5. A complementary logic IC according to claim 1 or 4, characterized in that said pull-up and pull-down elements are constituted by a depletion type FET whose gate is connected to the source electrode (Fig. 4.2).

6. A complementary logic IC according to claim 4, characterized in that said pull-up and pull-down elements are constituted by a FET whose gate is connected to the drain (Fig. 4.3), said FET having a lower threshold voltage than the bipolar transistors.

7. A complementary logic IC according to claim 1 or 4, characterized in that said pull-up element is constituted by an n-channel FET (Q_9), and said pull-down element is constituted by a p-channel FET (Q_10), the gates of said pull-up and pull-down elements (Q_9, Q_10) being connected to the collectors of said pnp and npn bipolar transistors (Q_3, Q_4), or to the drains of said p-channel and n-channel vertical FETs (Q_7, Q_8).

**Patentansprüche**

1. Komplementäre Logik-IC (Integrierte Schaltung) mit einer Eingangsstufenschaltung, welche einen MIS-FET (Q_1, Q_6) mit einem Kanal von einem ersten Leitfähigkeitstyp und einen MIS-FET (Q_2; Q_5) mit einem Kanal vom entgegengesetzten Leitfähigkeitstyp hat, deren Gates miteinander verbunden sind und ein Eingangssignal (IN) empfangen, gekennzeichnet durch:

eine Ausgangsstufenschaltung, welche einen p-Kanal V-FET (vertikalen FET) (Q_7) und einen n-Kanal-V-FET (Q_8) umfaßt, deren Drains miteinander verbunden sind und ein Ausgangssignal (OUT) liefern und deren Sourcen jeweils mit einer positiven bzw. einer negativen Spannungsversorgungsquelle verbunden sind, wobei jeder der genannten MIS-FETs jeweils zwischen Gate und Drain der genannten p-Kanal- bzw. n-Kanal-V-FETs verbunden ist; und

Pull-up und Pull-down-Elemente (I_U, I_D), die jeweils zwischen dem Gate und der Spannungsversorgungsquelle des genannten p-Kanal- bzw. n-Kanal-V-FET (Q_7, Q_8) verbunden sind.

2. Komplementäre Logik-IC nach Anspruch 1, dadurch gekennzeichnet, daß die genannten Pull-up- und Pull-down-Elemente durch einen Widerstand (R) gebildet sind.

3. Komplementäre Logik-IC nach Anspruch 2, dadurch gekennzeichnet, daß der Widerstand einen Widerstandswert hat, welcher zwischen ein- und zehnfachen des Ein-Widerstands der genannten MIS-FETs liegt.

4. Komplementäre Logik-IC (Integrierte Schaltung) mit:

einer Ausgangsstufenschaltung, welche einen pnp-Typ-Bipolartransistor (Q_3) und einen npn-Typ-Bipolartransistor (Q_4) umfaßt, deren Kollektoren miteinander verbunden sind und ein Ausgangssignal (OUT) liefern, und deren Emitter jeweils mit einer positiven und einer negativen Spannungsversorgungsquelle (V_+, V_-) verbunden sind, und

einer Eingangsstufenschaltung, welche einen MIS-FET (Metall-Isolator-Halbleiter-Typ-Feldeffekttransistor) (Q_1, Q_6) mit einem Kanal von einem ersten Leitfähigkeitstyp und einen MIS-FET (Q_2, Q_5) mit einem Kanal vom entgegengesetzten Leitfähigkeitstyp umfaßt, die jeweils zwischen der Basis und dem Kollektor der genannten pnp- und npn-Typ-Bipolar-transistoren verbunden sind, und deren Gates miteinander verbunden sind und ein Eingangssignal (IN) empfangen, gekennzeichnet durch die Tatsache, daß Pull-up- und Pull-down-Elemente, die durch entsprechende FETs (Q_9, Q_10) gebildet sind, jeweils die Basis und die Spannungsversorgungsquelle des genannten pnp- bzw. npn-Bipolartransistors (Q_3, Q_4) mittels des Kanalabschnitts der genannten FETs verbinden, wobei die Gates der genannten FETs so verbunden sind, daß die Pull-up- bzw. Pull-down-Funktion erzielt wird.

5. Komplementäre Logik-IC nach Anspruch 1 oder 4, dadurch gekennzeichnet, daß die Pull-up- und Pull-down-Elemente durch einen Verarmungstyp-FET gebildet sind, dessen Gate mit der Sourceelektrode (Fig. 4.2) verbunden ist.

6. Komplementäre Logik-IC nach Anspruch 4, dadurch gekennzeichnet, daß die genannten Pull-up- und Pull-down-Elemente durch einen FET gebildet sind, dessen Gate mit dem Drain (Fig. 4.3) verbunden ist, welcher FET eine niedrigere Schwellenwertspannung als die bipolaren Transistoren hat.

7. Komplementäre Logik-IC nach Anspruch 1 oder 4, dadurch gekennzeichnet, daß das genannte Pull-up-Element durch einen n-Kanal-FET (Q_9) gebildet ist, und das genannte Pull-down-Element durch einen p-Kanal-FET (Q_10) gebildet ist, die Gates der genannten Pull-up- und Pull-down-Elemente (Q_9, Q_10) mit den Kollektoren der genannten pnp- und npn-Bipolartransistoren (Q_3, Q_4) verbunden sind, oder mit den Drains der genannten p-Kanal- und n-Kanal-vertikal-FETs (Q_7, Q_8).

**Revendications**

1. Circuit intégré à logique complémentaire contenant un circuit étage d'entrée qui comprend un FET à MIS à canal d'un premier type de conductivité (Q_1; Q_6) et un FET à MIS à canal du type opposé de conductivité (Q_2; Q_5),

dont les grilles sont connectées l'une à l'autre et reçoivent un signal d'entrée (IN), caractérisé par:

un circuit étage de sortie qui comprend un V-FET (FET vertical) à canal p (Q$_7$) et un V-FET à canal n (Q$_8$), dont les drains sont connectés l'un à l'autre et fournissent un signal de sortie (OUT), et dont les sources sont respectivement connectées à une source d'alimentation de tension positive et à une source d'alimentation de tension négative, chacun desdits FET à MIS étant connecté respectivement entre la grille et le drain desdits V-FET à canal p et à canal n; et

des éléments de tirage vers le haut et de tirage vers le bas (I$_U$, I$_D$) respectivement disposés entre la grille et la source d'alimentation en tension desdits V-FET à canal p et à canal n (Q$_7$, Q$_8$).

2. Circuit intégré à logique complémentaire selon la revendication 1, caractérisé en ce que les éléments de tirage vers le haut et de tirage vers le bas sont constitués par une résistance (R).

3. Circuit intégré à logique complémentaire selon la revendication 2, caractérisé en ce que ladite résistance possède une valeur de résistance comprise entre une et dix fois la résistance d'état conducteur desdits FET à MIS.

4. Circuit intégré à logique complémentaire comprenant:

un circuit étage de sortie que comprend un transistor bipolaire du type pnp (Q$_3$) et un transistor bipolaire du type npn (Q$_4$), dont les collecteurs sont connectés l'un à l'autre et fournissent un signal de sortie (OUT), et dont les émetteurs sont connectés respectivement à des sources d'alimentation de tension positive et de tension négative (V$_+$, V$_-$), et un circuit étage d'entrée qui comprend un FET à MIS (transistor à effet de champ du type métal-isolant-semiconducteur) à canal d'un premier type de conductivité (Q$_1$; Q$_6$) et un FET à MIS à canal du type opposé de

conductivité (Q$_2$; Q$_5$), qui sont chacun connectés respectivement entre la base et le collecteur desdits transistors bipolaires de type pnp et npn, et dont les grilles sont connectées l'une à l'autre et reçoivent un signal d'entrée (IN), caractérisé par le fait que les éléments de tirage vers le haut et de tirage vers la bas constitués par des FET (Q$_9$, Q$_{10}$) connectent respectivement la base et la source d'alimentation en tension desdits transistors bipolaires pnp et npn (Q$_3$, Q$_4$) par l'intermédiaire de la partie de canal desdits FET, la grille desdits FET étant connectée de façon que la fonction de tirage vers le haut ou la fonction de tirage vers le bas soit respectivement obtenue.

5. Circuit intégré à logique complémentaire selon la revendication 1 ou 4, caractérisé en ce que lesdits éléments de tirage vers le haut et de tirage vers le bas sont constitués par un FET du type appauvrissement dont la grille est connectée à l'électrode de source (figure 4.2).

6. Circuit intégré à logique complémentaire selon la revendication 4, caractérisé en ce que lesdits éléments de tirage vers le haut et de tirage vers le bas sont constitués par un FET dont la grille est connectée au drain (figure 4.3), ledit FET ayant une tension de seuil inférieure à celle des transistors bipolaires.

7. Circuit intégré à logique complémentaire selon la revendication 1 ou 4, caractérisé en ce que ledit élément de tirage vers le haut est constitué par un FET à canal n (Q$_9$) et ledit élément de tirage vers le bas est constitué par un FET à canal p (Q$_{10}$), les grilles dedits éléments de tirage vers le haut et de tirage vers le bas (Q$_9$, Q$_{10}$) étant connectées aux collecteurs desdits transistors bipolaires pnp et npn (Q$_3$, Q$_4$), ou aux drains desdits FET verticaux à canal p et à canal n (Q$_7$, Q$_8$).

# FIG. 1a

PRIOR ART

# FIG. 1b

# FIG. 2 a

# FIG. 2 b

# FIG. 3 a

# FIG. 3 b

# FIG. 4

4·1 — R

4·2 — (p-channel: S, G, D, p) (n-channel: G, D, n, S)

4·3 — (p-channel: S, G, D, p) (n-channel: D, G, n, S)

0 134 731

*FIG. 5 a*

*FIG. 5 b*

$V_+$

$Q_9$

$n$

$A$

$Q_3$

$P$ $Q_1$

IN

OUT

$n$ $Q_2$

$B$

$Q_4$

$P$ $Q_{10}$

$V_-$

$V_+$

$Q_9$

$n$

$Q_3$

$Q_5$

$n$

IN

OUT

$P$ $Q_6$

$Q_4$

$P$ $Q_{10}$

$V_-$